# EUROPÄISCHE PATENTSCHRIFT

(11) **EP 0 979 420 B1**
(45) Veröffentlichungstag und Bekanntmachung des Hinweises auf die Patenterteilung: **12.09.2001**
(21) Anmeldenummer: 98932021.3
(22) Anmeldetag: 29.04.1998
(51) Int. Cl.: G01R 33/025, H05K 9/00, H01J 37/09, G05F 7/00, G01R 33/389

(54) **VORRICHTUNG UND VERFAHREN ZUR AKTIVEN KOMPENSATION MAGNETISCHER UND ELEKTROMAGNETISCHER STÖRFELDER**
METHOD AND DEVICE FOR ACTIVE COMPENSATION OF MAGNETIC AND ELECTROMAGNETIC DISTURBANCE FIELDS
DISPOSITIF ET PROCEDE POUR LA COMPENSATION ACTIVE DE CHAMPS PERTURBATEURS MAGNETIQUES ET ELECTROMAGNETIQUES

(30) Priorität: 02.05.1997 DE 19718649
(43) Veröffentlichungstag der Anmeldung: 16.02.2000
(73) Patentinhaber: Heiland, Peter, 65479 Raunheim (DE)
(72) Erfinder: Heiland, Peter, 65479 Raunheim (DE)
(74) Vertreter: Herden, Andreas F.
(86) Internationale Anmeldenummer: DE9801177
(87) Internationale Veröffentlichungsnummer: WO9850798

(56) Entgegenhaltungen:
- EP-A- 0 514 027
- DE-A- 4 217 302
- US-A- 3 801 877
- US-A- 5 586 064

## Beschreibung

Die Erfindung betrifft eine Vorrichtung und ein Verfahren zur aktiven Kompensation magnetischer und vorzugsweise auch elektromagnetischer Storfelder in einem vorgegebenen Volumenbereich.

Die heutige Meßtechnik ermöglicht die Erfassung elektromagnetischer Strahlung sowie von Magnetfeldern mit extrem niedrigen Amplituden. So können beispielsweise in der Medizintechnik mit Hilfe der Kernspinresonanz (NMR: Nuclear Magnetic Resonance) und insbesondere der bildgebenden Kernspinresonanz (MRI: Magnetic Resonance Imaging) Amplituden im Bereich von kleiner 10 nT/√Hz erfaßt werden. SQUID-Sensoren (SQUID: Superconducting Quantum Interference Device) erfassen sogar Signalpegel bis in den Bereich von etwa 100 FT/√Hz.

Derartige kleine Feldamplituden der Nutzsignale liegen jedoch nahe beziehungsweise teilweise unterhalb der in der Regel gegenwärtigen elektromagnetischen und magnetischen Störfelder.

Solche Störfelder können beispielsweise durch bewegte Metallmassen wie Aufzüge, Eisenbahnen und Kraftfahrzeuge hervorgerufen werden. Die Frequenz derartiger Störfelder liegt im Bereich von Null bis etwa 10 Hertz. Ferner können durch asymmetrisch belastete Stromversorgungseinrichtungen Störungen im Bereich von 50 Hertz und deren Harmonische erzeugt werden. Die beschriebenen Störfelder verursachen bei MRI-Messungen sogenannte "Geisterbilder" während sie eine Resonanzverschiebungen bei NMR-Messungen zur Folge haben.

Eine herkömmliche Vorrichtung zur aktiven Kompensation elektromagnetischer und insbesondere magnetischer Störfelder in einem vorgegebenen Volumenbereich wird beispielsweise sowohl bei MRI-Geräten als auch bei Elektronenstrahlgeräten für die Lithographie und Mikroskopie angewandt. Beispielsweise werden die aus der Kathode eines Elektronenrastermikroskops emittierten Elektronen während des Rasterns der Probe durch elektromagnetische Felder, welche z.B. durch Spulen hervorgerufen werden, in vorgegebener Weise abgelenkt. Die auch im Mikroskop vorhandenen magnetischen und elektromagnetischen Störfelder beeinflussen den Weg der Elektronen zur Probe derart, daß der Auftreffpunkt nur mit einer gewissen Unschärfe angegeben werden kann. Aus diesem Grund werden Spulen an den Wänden des Raumes angebracht, in dem sich das Elektronenmikroskop befindet. Im Raum wird mit Hilfe eines Flux-Gate Sensors das magnetische Störfeld gemessen und das so erhaltene elektrische Signal mittels digitaler Signalverarbeitung mit negativer Rückkopplung zum Ansteuern der an den Wänden befindlichen Spulen verwendet.

Ein auf diese Weise realisiertes System zur aktiven Kompensation von magnetischen und elektromagnetischen Störfeldern weist den Nachteil auf, daß zwar die Störfelder möglicherweise exakt kompensiert werden, diese Aussage aber nur am Ort des Sensors volle Gültigkeit hat. Ein derartiges Verfahren weist somit in jedem Fall einen systematischen Fehler auf.

Es ist jedoch nicht möglich, den Sensor, dessen Signal zur negativen Rückkopplung verwendet wird, nahe der Elektronenbahnen im Mikroskop anzuordnen, da dann durch diese negative Rückkopplung auch das zur definierten Ablenkung der Elektronen verwendete elektromagnetische Feld kompensiert wird.

In ähnlicher Weise ist das Ziel einer derartigen aktiven Kompensation von Störfeldern bei MRI-Systemen eine Verminderung der störenden Umgebungsfelder in drei zueinander senkrechten Achsen. Die Storpegel variieren hier in der Regel von 0.1 µT/√Hz bis 10 µT/√Hz und müssen bis auf etwa 10 nT/√Hz reduziert werden. Auch in diesem Fall kann der Sensor zur Steuerung der negativen Rückkopplung nicht im Meßraum angeordnet werden, da ansonsten das Meßsignal durch die Magnetfeldkompensation zumindest verfälscht wird.

Parallel zur Steigerung der Meßempfindlichkeit entwickelte sich somit das Bedürfnis, vorhandene elektromagnetische Störfelder zu unterdrücken um die Meßauflösung weiter zu verbessern, das Potential heutiger Sensoren voll auszunutzen und um elektrisch geladene Teilchen mit Hilfe definierter elektromagnetischer Felder genauer steuern zu können. Ferner ist die Bereitstellung von Umgebungsbedingungen mit magnetischen und elektromagnetischen Rauschpegeln, die sehr viel niedriger liegen als der erwartete Signalpegel eine Schwelle für die erfolgreiche kommerzielle Ausnutzung derartiger Technologien.

In EP 0 514 027 A2 ist eine Vorrichtung zur Verminderung magnetischer Störungen offenbart, welche einen SQUID-Sensor und ein die magnetische Störung aufhebendes Spulenpaar aufweist, wobei das Sensorsignal in die Spulen rückgekoppelt wird. Dieser Vorrichtung haftet der schon obenstehend beschriebene Nachteil an, daß Störfelder vollständig nur am Ort des Sensors kompensiert werden.

Aufgabe der Erfindung ist es somit, elektromagnetische und insbesondere magnetische Störfelder am eigentlichen "Ort des Geschehens" zu kompensieren, ohne ein vorhandenes Nutzsignal wesentlich zu beeinflussen.

Diese Aufgabe wird überraschend einfach mit einer Vorrichtung nach Anspruch 1 und einem Verfahren nach Anspruch 12 gelöst.

Hierbei wird eine Vorrichtung zur aktiven Kompensation magnetischer und/oder elektromagnetischer Störfelder in einem vorgegebenen Volumenbereich mittels mindestens einer Helmholtzspule, welche den vorgegebenen Volumenbereich im wesentlichen umschließt, und einer Einrichtung zur Ansteuerung der Helmholtzspule in Abhängigkeit von Sensorsignalen bereitgestellt, bei welcher mindestens ein erster Sensor innerhalb des vorgegebenen Volumenbereichs zur Erzeugung eines Signals angeordnet ist, das vom magnetischen und/oder elektromagnetischen Feld am Ort des Sensors abhängt. Ferner ist mindestens ein zweiter Sensor außerhalb des vorgegebenen Volumenbereichs zur Erzeugung eines Signals angeordnet, das vom magnetischen und/oder elektromagnetischen Feld am Ort des Sensors abhängt. Das Signal des ersten und zweiten Sensors wird als Eingangssignal zum Ansteuern eines der Helmholtzspule zugehörigen Reglerverstärkers verwendet. Das Signal des ersten Sensors liegt beispielsweise nach Durchlaufen einer in der Regel empirisch bestimmten Übertragungsfunktion am Reglereingang des digital ausgebildeten Reglerverstärkers an, und das Ausgangssignal des digitalen Reglerverstärkers steuert den Strom durch die Helmholtzspule derartig, daß das magnetische und/oder elektromagnetische Störfeld in dem vorgegebenen Volumenbereich wenigstens teilweise kompensiert wird.

Das aufbereitete elektrische Signal des zweiten Sensors außerhalb des vorgegebenen Volumens wird vorteilhafterweise verstärkt und in die Spulen, je nach Anordnung des zweiten Sensors zur Helmholtzspule, vorwärtsgekoppelt oder rückgekoppelt, während das elektrische Signal des ersten Sensors innerhalb des vorgegebenen Volumens als Störsignal die "Güte" der Störfeld-Kompensation anzeigt und adaptiv zum Einstellen der Parameter der Vorwärtskopplung verwendet wird.

Auf diese Weise kann vorteilhafterweise das Störfeld am eigentlich relevanten Ort, beispielsweise auf den Elektronenbahnen in einem Elektronenmikroskop gezielt kompensiert werden.

Die Vorrichtung kann auch zur aktiven Kompensation von magnetischen und/oder elektromagnetischen Störfeldern in einem vorgegebenen Volumengebiet in drei Dimensionen verwendet werden, wenn die Vorrichtung mit einer Vielzahl von Sensoren zur Erfassung magnetischer und/oder elektromagnetischen Felder in alle drei Raumrichrungen ausgestattet ist und deren elektrische Signale zur Ansteuerung des digitalen Reglerverstärkers verwendet werden und mit den Ausgangssignalen der digitalen Reglerverstärkereinheit der Strom durch die Spulen eines dreiachsigen Helmholtzkäfigs derartig gesteuert ist, daß die elektromagnetische Störfelder in alle drei Raumrichtungen innerhalb des vorgegebenen Volumens im wesentlichen kompensiert werden.

Umfaßt der vorgegebene Volumenbereich im wesentlichen das gesamte Volumen innerhalb des Helmholtzkäfigs, d.h. befindet sich der zweite Sensor außerhalb des Helmholtzkäfigs, so wird das aufbereitete elektrische Signal des zweiten Sensors vorteilhafterweise verstärkt und in die Spulen vorwärtsgekoppelt, wobei das elektrische Signal des ersten Sensors die Qualität der Störfeld-Kompensation anzeigt und zum Einstellen der Parameter der Vorwärtskopplung verwendet wird.

Schließt dagegen der vorgegebene Volumenbereich nur einen begrenzten Volumenabschnitt innerhalb des Helmholtzkäfigs ein und ist der zweite Sensor auch innerhalb des Helmholtzkäfigs angeordnet, so wird das aufbereitete elektrische Signal des zweiten Sensors vorteilhafterweise verstärkt und in die Spulen mit negativer Rückkopplung eingespeist, wobei das elektrische Signal des ersten Sensors wiederum die Qualität der Störfeld-Kompensation anzeigt und zum Einstellen der Parameter der Rückkopplung verwendet wird. Eine derartige Anordnung kann beispielsweise zum Einstellen der Rückkopplungsparamter bei einer herkömmlichen Kompensationseinrichtung mit negativem Feedback eingesetzt werden. Somit kann das üblicherweise nur durch einen Fachmann manuell durchführbare und umständliche Einstellen der Rückkopplungsparameter der negativen Rückkopplung in herkömmlichen Systemen zur Störfeld-Kompensation statt dessen automatisch realisiert werden.

Je nach Anwendung und je nach Bedarf läßt sich das Prinzip der Erfindung mit einer Vielzahl von Feldsensoren in und außerhalb des vorgegebenen'Volumens durchführen wie z.B. Spulen, Flux-Gate-Sensoren, ESR-Sensoren, MNR-Sensoren, SQUID-Sensoren und Halleffekt-Sensoren. Vorteilhafterweise können auch unterschiedliche Sensoren gleichzeitig verwendet werden, beispielsweise ein Flux-Gate-Sensor außerhalb des vorgegebenen Volumens und ein SQUID-Sensor im Helmholtzkäfig oder mehrere verschiedene Sensoren außerhalb (als zweite Sensoren) und/oder innerhalb (als erste Sensoren) des Käfigs. Diese hohe Flexibilität stellt sicher, daß sich das erfindungsgemäße Verfahren immer optimal auf die jeweiligen elektromagnetischen Stör- und Nutzfelder adaptieren läßt.

Aufgrund dieser hohen Anpassungsfähigkeit des Verfahrens läßt sich die erfindungsgemäße Vorrichtung für die aktive magnetische und/oder elektromagnetische Abschirmung von vielen Messungen oder Arbeitsabläufen nutzen, bei denen magnetische und/oder elektromagnetische Felder als Nutzfelder, die beispielsweise als Nutzsignal erfaßt oder zum Steuern elektrischer Teilchen verwendet werden, eine Rolle spielen.

Vorteilhafterweise läßt sich erfindungsgemäß der oder die erste(n) Sensor(en) wenigstens teilweise dadurch ersetzen und damit einsparen, daß in dem vorgegenenen Volumen vorhandene ein oder mehrere dritte(r) Sensor(en) zur Erfassung eines Nutzsignals, bespielsweise NMR-Aufnehmer in einem NMR-System oder ein SQUID-Sensor in einem SQUID-System, gleichzeitig auch als erste(r) Sensor(en) zur Erfassung des Störsignals verwendet werden. In einer weiteren Ausgestaltung der Erfindung kann die Vorrichtung einen magnetisch abgeschirmten Raum (MSR) umfassen. Hierbei sind die Helmholtzspulen außen an den magnetisch abgeschirmten Raumes angebracht und mindestens ein zweiter Sensor außerhalb des vorgegebenen Volumenbereichs und mindestens ein erster Sensor innerhalb des magnetisch abgeschirmten Raumes im vorgegebenen Volumenbereich angeordnet. Vorteilhaft läßt sich die Erfindung leicht mit passiven magnetischen Abschirmverfahren wie beispielsweise einem schon erwähnten magnetisch abgeschirmten Raum (magnetically shielded room, MSR) koppeln, um eine bisher unerreichte Unterdrückung der magnetischen und/oder elektromagnetischen Störfelder zu erhalten. Auf diese Weise konnte die Dämpfung in einem MSR mit aktiver erfindungsgemäßer Kompensation bei 0.1 Hz um 35 dB im Vergleich zur Dämpfung in einem MSR ohne aktive Unterdrückung gesteigert werden. Gerade im Frequenzbereich mit einer Mittenfrequenz von 0.1 bis 0.2 Hz, in dem die Störfeld-Unterdrückung eines herkömmlichen MSR's im Vergleich zu anderen Frequenzbereichen konstruktionsbedingt vermindert ist, bietet die erfindungsgemäße zusätzliche aktive Kompensation der magnetischen und/oder elektromagnetischen Störungen eine starke Verbesserung gegenüber Vorrichtungen nach dem Stande der Technik.

Unter bestimmten Umständen läßt sich durch den Einsatz der erfindungsgemäßen Störfeldunterdrückung die Verwendung eines magnetisch abgeschirmten Raumes sogar ganz einsparen beziehungsweise mit einfacheren Mitteln realisieren.

Die erfindungsgemäße Vorrichtung kann weiterhin vorteilhafterweise zur Abschirmung einer Vielzahl von Systemen Verwendung finden, in denen magnetische und/oder elektromagnetische Störfelder eine Rolle spielen können, beispielsweise von NMR-Systemen, MRI-Systemen, ESR-Systemen, in Elektronenstrahl-Systemen und Beschleuniger-Systemen (z.B. Linearbeschleuniger).

Einige Ausführungsformen der Erfindung werden im folgenden unter Bezugnahme auf die anliegenden Zeichnungen detaillierter erläutert. Es zeigen:
Fig. 1 ein schematisches Blockschaltbild einer Ausführungsform der erfindungsgemäßen Vorrichtung zur aktiven Kompensation von magnetischen und/oder elektromagnetischen Störfelder innerhalb eines vorgegebenen Volumens, bei der ein zweiter Sensor 1 außerhalb des Helmholtzkäfigs und ein erster Sensor 2 innerhalb des vorgegebenen Volumens im Helmholtzkäfig angeordnet ist;
Fig. 2 im Vergleich den Verlauf der Dämpfung des magnetischen Störfeldes in Abhängigkeit der Frequenz in vertikaler Richtung in einem magnetisch abgeschirmten Raum ohne bzw. mit erfindungsgemäßer aktiver Kompensation gemäß der in Fig. 1 dargestellten Ausführungsform; und
Fig. 3 ein schematisches Blockschaltbild einer weiteren Ausführungsform der erfindungsgemäßen Vorrichtung, in welcher ein zweiter Sensor 1 innerhalb des Helmholtzkäfigs und ein erster Sensor 2 innerhalb des vorgegebenen Volumens im Helmholtzkäfig angeordnet sind.

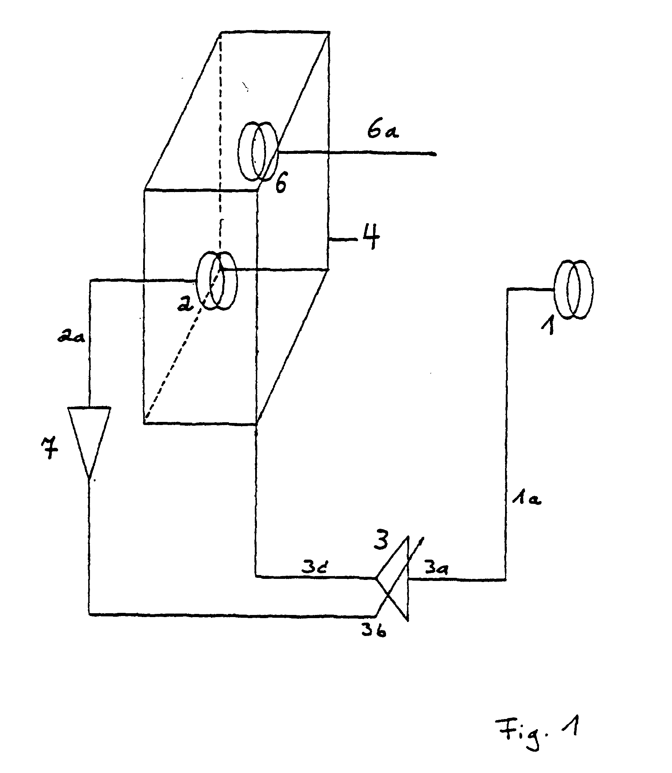

In Fig. 1 ist ein schematisches Blockschaltbild einer Ausführungsform der erfindungsgemäßen Vorrichtung zur aktiven Kompensation von elektromagnetischen Störfelder innerhalb eines vorgegebenen Volumens dargestellt. Die Vorrichtung umfaßt mindestens eine Helmholtzspule, welche den vorgegebenen Volumenbereich im wesentlichen umschließt. Dabei umfaßt der vorgegebene Volumenbereich im erfindungsgemäßen Sinne ein Volumen, innerhalb dessen die magnetischen und/oder elektrischen Störungen Auswirkungen auf bilderfassende oder bildgebende Abläufe haben. Der vorgegebene Volumenbereich umfaßt dabei zumindest das Volumen innerhalb dessen die genannten Störungen kompensiert werden sollen. Bei einer Teilkompensation können auch definierte Volumenbereiche ausgewählt werden, wie beispielsweise abbildende Linsen und Strahlengänge in Elektronenmikroskopen oder Targetbereiche in Beschleunigern, Strahlengänge und Optiken in Elektronenstrahllithographieanlagen etc..

Weiterhin ist mindestens ein zweiter Sensor 1 außerhalb der Helmholtzspulen zur Erzeugung eines elektrischen Signals 1a, das vom elektromagnetischen Feld am Ort des Sensors 1 abhängt, und mindestens ein erster Sensor 2 innerhalb des vorgegebenen Volumenbereichs zur Erzeugung eines elektrischen Signals 2a, das vom elektromagnetischen Feld am Ort des Sensors 2 abhängt, angeordnet. Die Signale des ersten und zweiten Sensors (1a, 2a) steuern als Eingangssignale (3a, 3b) einen den Helmholtzspulen zugeordneten Reglerverstärker 3 an. Insbesondere wird das elektrische Signal 1a als Eingangssignal 3a zum Ansteuern des Signaleingangs der digitalen Reglerverstarkereinheit 3 verwendet, und das elektrische Signal 2a wird nach Durchlaufen der empirisch bestimmten Übertragungsfunktion H_{S} (in Fig. 1 durch das Filter 7 beschrieben) als Eingangssignal 3b am Reglereingang der digitalen Reglerverstärkereinheit 3 angelegt. Das Ausgangssignal 3c der digitalen Reglerverstärkereinheit 3 steuert den Strom durch die Helmholtzspulen. Diese Helmholtzspulen können erfindungsgemäß so angeordnet sein, daß sie das Störfeld im wesentlichen in einer oder zwei Raumrichtungen kompensieren, es kann jedoch auch ein Helmholtzkäfig 4, der den vorgegebenen Volumenbereich einschließt, derart gestaltet sein und von der digitale Verstärkereinheit 3 derartig stromangesteuert werden, daß der hervorgerufene Stromfluß durch den Helmholtzkäfig 4 im vorgegebenen Volumenbereich in allen drei Raumrichtungen das elektromagnetische und/oder magnetische Störfeld im wesentlichen kompensiert.

In diesem Fall erfassen die Sensoren 1 und 2 die Meßgrößen in drei Raumrichtungen beziehungsweise ist für jede Raumrichtung mindestens ein Sensor innerhalb und außerhalb des vorgegebenen Volumenbereiches vorgesehen und die digitale Reglerverstärkereinheit 3 ist zum Verarbeiten mehrdimensionaler Meßgrößen und zum Stromansteuern des Helmholtzkäfig eingerichtet.

Im vorliegenden Fall der in Fig. 1 dargestellten Ausführungsform umfaßt das vorgegebene Volumen im wesentlichen das Innere des Helmholtzkäfigs, d.h. der zweite Sensor ist außerhalb des Helmholtzkäfigs angeordnet. Somit wird das aufbereitete elektrische Signal des zweiten Sensors außerhalb des vorgegebenen Volumens erfindungsgemäß verstärkt und in die Spulen vorwärtsgekoppelt während das elektrische Signal des ersten Sensors innerhalb des vorgegebenen Volumens zum adaptiven Einstellen der Parameter dieser Vorwärtskopplung verwendet wird. Hierbei werden relevanten Parameter wie Verstärkung und Phasenlage richtungsabhängig mittels eines adaptiven Verfahrens beispielsweise über die Minimierung des kleinsten mittleren quadratischen Fehlers des Störsignals, das vom magnetischen und/oder elektromagnetischen Storfeld abhängt, bestimmt. Andere Minimierungsverfahren sind dem Fachmann wohlbekannt und bedürfen keiner weiteren Erläuterung. Die Regelparameter werden verändert und das Resultat einer Messung des Störsignals im vorgegebenen Volumenbereich entsprechend dem Verfahren als Grundlage für eine neue Einstellung der Parameter genommen. Das gemessene Störsignal durchläuft das Filter 7 mit einer empirisch bestimmten Übertragungsfunktion H_{S}, was einer mathematischen Faltung des Sensor-Zeit-Signals mit der Impulsantwort hₛ des Systems H_{S} entspricht. Mit dem gefalteten Signal wird nun der Reglereingang der digitalen Reglerverstärkereinheit zur Einstellung der Reglerparameter angesteuert. Die optimalen Regelparameter sind die, bei welchen das magnetische oder/und elektromagnetische Störfeld im vorgegebenen Volumenbereich minimiert ist. H_{S} entspricht einer Nachbildung des Übertragungsweges vom Reglerausgang bis zum inneren Sensor 2, d.h. H_{S} kann natürlich auch mit Hilfe eines handelsüblichen FFT-Analysators ermittelt werden. Unter der Voraussetzung, daß die im Filter 7 und dem Regelverstärker modellierten Übertragungstrecken zeitlich stabil sind, kann der Sensor 2 abgeschaltet und die ermittelten Übertragungsparameter des Reglerverstärkers 3 beibehalten werden. In einer anderen Ausführungsform wird der Sensor 2 nicht abgeschaltet und die Regelparameter über das beschriebene adaptive Verfahren kontiniuierlich geänderten Umgebungsbedingungen angepaßt.

Als zweite Sensoren 1 und erste Sensoren 2 werden je nach Anforderung alle magnetischen Feldsensoren wie z. B. Spulen, Flux-Gate-Sensoren, ESR-Sensoren, MNR-Sensoren, SQUID-Sensoren und Halleffekt-Sensoren benutzt. Beispielsweise findet in einem NMR-System innerhalb des vorgegebenen Volumens ein NMR-Sensor als erster Sensor Verwendung. Erfindungsgemäß werden in einer Ausführungsform der Erfindung auch unterschiedliche Sensoren gleichzeitig angewendet, beispielsweise ein Flux-Gate-Sensor außerhalb des vorgegebenen Volumens und ein SQUID-Sensor im Helmholtzkäfig oder mehrere verschiedene Sensoren außerhalb und/oder innerhalb des Käfigs zur Erzielung einer möglichst ortsabhängigen Kompensation des elektromagnetischen Störfeldes in dem vorgegebenen Volumenbereich.

In einer anderen Ausführungsform ist ein weiterer Sensor 6 im Innern des vorgegenenen Volumenbereichs zur Erfassung eines Nutzsignals, beispielsweise ein NMR-Sensor bzw. ein ESR-Sensor in einem NMR- bzw. ERS-System angeordnet. In einer weiteren Ausführungsform ist dieser Sensor 6 zur Erfassung des Störsignals, daß vom magnetischen und/oder elektromagnetischen Störfeld abhängt und zur Erfassung des Nutzsignals, daß vom magnetischen und/oder elektromagnetischen Nutzfeld abhängt, eingerichtet. Als Nutzfeld sind beispielsweise die durch menschliche Hirnstöme erzeugten elektromagnetischen Felder in einem SQUID-System oder das elektromagnetische Feld in einer Beschleunigereinrichtung zum Beschleunigen elektrisch geladener Teile anzusehen. Nutz- und Störsignale lassen sich beispielsweise durch ein in der Regel vorhandenes unterschiedliches spektrales Verhalten der Signale trennen.

In verschiedenen Ausführungsformen kann die Vorrichtung zur Abschirmung einer Vielzahl von Systemen, beispielsweise von NMR-Systemen, MRI-Systemen, ESR-Systemen, in Elektronenstrahl-Systemen und Beschleuniger-Systemen (z.B. Linearbeschleuniger) ausgenutzt werden.

Ferner wurde die Erfindung der aktiven Abschirmung mit dem passiven magnetischen Abschirmverfahren eines magnetisch abgeschirmten Raumes gekoppelt. In der realisierten Ausführungsform der Erfindung wurden die Helmholtzspulen außen auf den MSR angebracht. Als Sensor 1 wurde ein Flux-Gate-Sensor und im Innern des vorgegebenen Volumens, d.h. im Innern des magnetisch abgeschirmten Raumes, als Sensor 6 ein SQUID-Sensor verwendet, der das Nutz- und das Störsignal erfaßte. Die Helmholtzspulen wurden mit einem DC- 2kHz Reglerverstärker angesteuert.

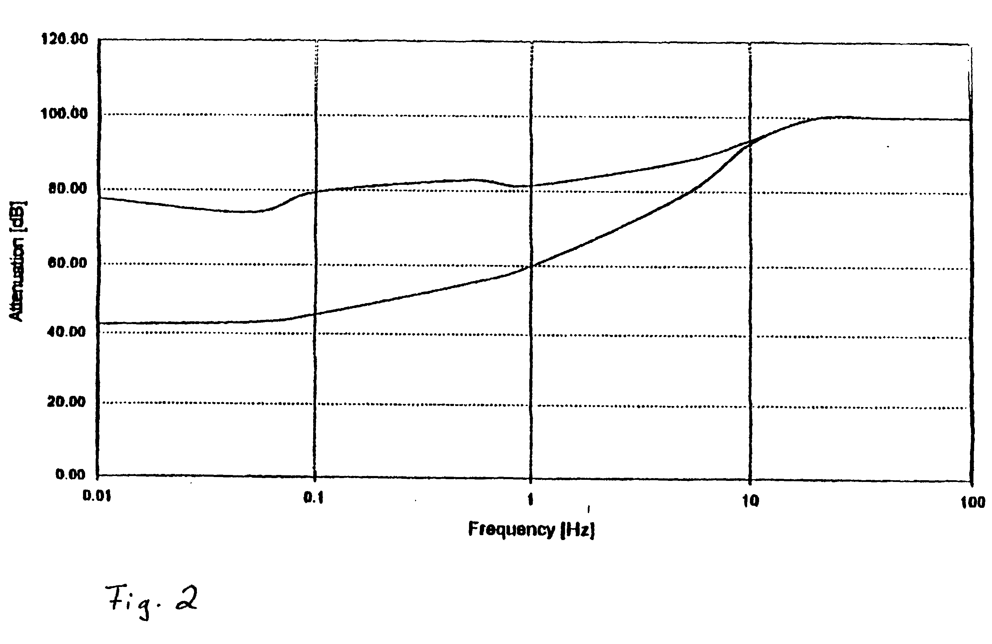

Fig. 2 zeigt das Ergebnis einer derartigen Kopplung der erfindungsgemäßen aktiven Kompensation und der passiven magnetischen Abschirmung in einem MSR für eine Fig. 1 entsprechenden Ausführungsform. Der Verlauf der Dämpfung in Abhängigkeit der Frequenz in vertikaler Richtung ohne bzw. mit erfindungsgemäßer aktiver Kompensation der elektromagnetischen Störfelder ist dargestellt. Im kritischen Bereich zwischen 0.1 und 0.2 Hz wird eine Erhöhung der Dämpfung um etwa 35 dB erreicht.

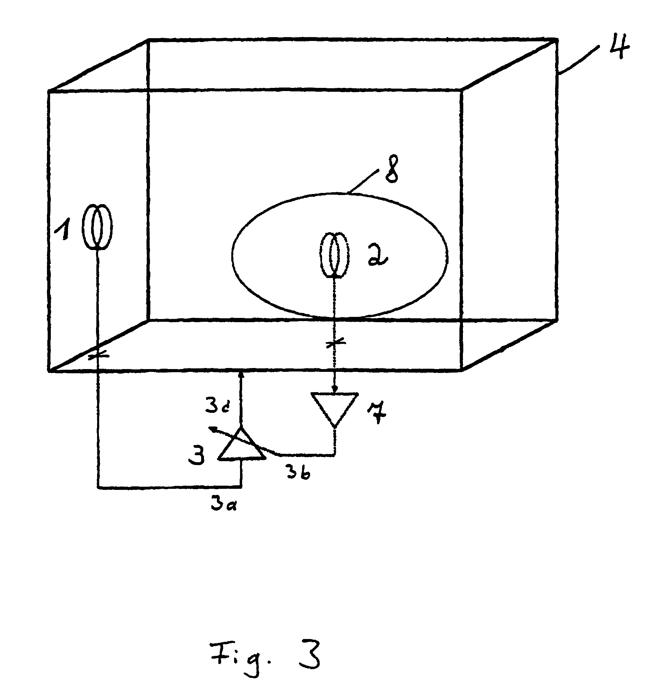

In einer in Fig. 3 dargestellten weiteren Ausführungsform wird die erfindungsgemäße Vorrichtung als System mit negativer Rückkopplung zur aktiven Kompensation elektromagnetischer und magnetischer Störfelder eingesetzt. Hierbei umfaßt das vorgegebene Volumen, in welchem die Kompensation im wesentlichen stattfindet, nur einen Volumenabschnitt 8 innerhalb des Helmholtzkäfigs 4 und der zweite Sensor 1 ist innerhalb des Helmholtzkäfigs, aber außerhalb des vorgegebenen Volumenbereichs angeordnet, in welchem wiederum der erste Sensor 2 angeordnet ist.

Somit wird das aufbereitete elektrische Signal des zweiten Sensors 1 erfindungsgemäß verstärkt und in die Spulen mit negativem Feedback zurückgekoppelt während das elektrische Signal des ersten Sensors 2 innerhalb des vorgegebenen Volumens zum adaptiven Einstellen der Parameter dieser Rückkopplung verwendet wird. Das Einstellen der für die Rückkopplung relevanten Parameter wird in analoger Weise wie für die in Fig. 1 dargestellte und obenstehend ausführlich diskutierte Ausführungsform durchgeführt.

Die optimalen Regelparameter sind auch hier eingestellt, wenn das magnetische oder/und elektromagnetische Störfeld im vorgegebenen Volumenbereich minimiert ist. Unter der Voraussetzung, daß die im Filter 7 und dem Regelverstärker modellierten Übertragungstrecken zeitlich stabil sind, kann je nach Ausführungsform der Sensor 2 abgeschaltet und die ermittelten Übertragungsparameter des Reglerverstärkers 3 beibehalten werden. Nach dem Entfernen des Sensors 2 und des Filters 7 arbeitet das System in der herkömmlichen Feedback-Anordnung. Der Regler 3 arbeitet nun jedoch derart, daß das Feedback-System die elektromagnetische Störung im vorgegebenen Volumen, hier den Volumenbereich 8, minimiert und nicht wie herkömmlich am Ort des Sensors 1. Die Vorrichtung arbeitet somit als "quasi-feedforward"-System.

Die in Fig. 3 dargestellte Ausführungsform wird je nach Anwendung wie die in Fig. 1 dargestellte Ausführungsform mit einer Vielzahl von Feldsensoren, wie beispielsweise Spulen, Flux-Gate-Sensoren, ESR-Sensoren, MNR-Sensoren, SQUID-Sensoren und Halleffekt-Sensoren benutzt. In ähnlicher Weise wird die in Fig. 3 dargestellte Ausführungsform zur Abschirmung einer Vielzahl von Systemen, beispielsweise von NMR-Systemen, MRI-Systemen, ESR-Systemen, in Elektronenstrahl-Systemen, Beschleuniger-Systemen (z.B. Linearbeschleuniger) und bei magnetischen abgeschirmten Räumen (MSR) eingesetzt.

## Patentansprüche

1. Vorrichtung zur aktiven Kompensation magnetischer und/oder elektromagnetischer Störfelder in einem vorgegebenen Volumenbereich mittels mindestens einer Helmholtzspule, welche diesen Volumenbereich im wesentlichen umschließt, und einer Einrichtung zur Ansteuerung der Helmholtzspule in Abhängigkeit von Sensorsignalen,
bei welcher mindestens ein erster Sensor (2) zur Erzeugung eines Signals (2a) , das vom magnetischen und/oder elektromagnetischen Feld am Ort des ersten Sensors (2) abhängt, innerhalb des vorgegebenen Volumenbereichs angeordnet ist und das Signal des ersten Sensors als Eingangssignal (3b) zum Ansteuern eines der Helmholtzspule zugehörigen Reglerverstärkers (3) verwendet wird,
**dadurch gekennzeichnet, daß**
mindestens ein zweiter Sensor (1) zur Erzeugung eines Signals (1a), das vom magnetischen und/oder elektromagnetischen Feld am Ort des Sensors (1) abhängt,außerhalb des vorgegebenen Volumenbereichs angeordnet ist und das Signal des zweiten Sensors (1a) auch als Eingangssignal (3a) zum Ansteuern des der Helmholtzspule zugehörigen Reglerverstärkers (3) verwendet wird.

2. Vorrichtung nach Anspruch 1, **dadurch gekennzeichnet, daß** das Signal des ersten Sensors (2a) nach Durchlaufen einer empirisch bestimmten Übertragungsfunktion (H_{S}) am Reglereingang (3b) des digital ausgebildeten Reglerverstärkers (3) anliegt, und das Ausgangssignal (3c) des digitalen Reglerverstärkers (3) den Strom durch die Helmholtzspule (4) steuert.

3. Vorrichtung nach Anspruch 1 oder 2,
**dadurch gekennzeichnet,**
**daß** eine Vielzahl von Sensoren (1, 2) magnetische und/oder elektromagnetische Felder in allen drei Raumrichtungen erfassen und deren Signale zur Ansteuerung des digitalen Reglerverstärkers verwendet werden und mit den Ausgangssignalen des digitalen Reglerverstärkers der Strom durch die Spulen eines dreiachsigen Helmholtzkäfigs derartig gesteuert ist, daß die magnetischen und/oder elektromagnetischen Störfelder in allen drei Raumrichtungen innerhalb des vorgegebenen Volumens im wesentlichen kompensiert werden.

4. Vorrichtung nach Anspruch 3,
**dadurch gekennzeichnet,**
**daß** der vorgegebene Volumenbereich das gesamte Volumen innerhalb des Helmholtzkäfigs umfaßt und somit der zweite Sensor außerhalb des Helmholtzkäfigs angeordnet ist.

5. Vorrichtung nach Anspruch 3,
**dadurch gekennzeichnet,**
**daß** der vorgegebene Volumenbereich einen begrenzten Volumenabschnitt (8) innerhalb des Helmholtzkäfigs einschließt und der zweite Sensor innerhalb des Helmholtzkäfigs angeordnet ist.

6. Vorrichtung nach einem der vorstehenden Ansprüche,
**dadurch gekennzeichnet,**
**daß** mindestens ein Sensor (1,2) des ersten und/oder des zweiten Sensors ein ESR-Sensor, ein NMR-Sensor, ein MRI-Sensor, ein Flux Gate-Sensor, eine Spule, ein SQUID-Sensor oder ein Halleffekt-Sensor ist.

7. Vorrichtung nach einem der vorstehenden Ansprüche,
**dadurch gekennzeichnet,**
**daß** in dem vorgegebenen Volumen mindestens ein Sensor (6) zur Erzeugung eines Nutzsignals (6a) angeordnet ist.

8. Vorrichtung nach Anspruch 7,
**dadurch gekennzeichnet,**
**daß** wenigstens ein Sensor (6) zur Erzeugung eines Nutzsignals (6a) und des Störsignals (2a) umfaßt ist.

9. Vorrichtung nach einem der vorstehenden Ansprüche 1, 2,3,4,6,7, oder 8,
**dadurch gekennzeichnet, daß** die Vorrichtung einen magnetisch abgeschirmten Raum (MSR) umfaßt, wobei sich die Helmholtzspulen (4) und mindestens ein zweiter Sensor (1) außerhalb und der vorgegebene Volumenbereich und mindestens ein erster Sensor (2) innerhalb des magnetisch abgeschirmten Raumes befinden.

10. Vorrichtung nach einem der vorstehenden Ansprüche 1, 2,3,5,6,7, oder 8,
**dadurch gekennzeichnet, daß** die Vorrichtung einen magnetisch abgeschirmten Raum (MSR) umfaßt, wobei sich die Helmholtzspulen (4) außerhalb und der vorgegebene Volumenbereich und der erste (2) und der zweite (1) Sensor innerhalb des magnetisch abgeschirmten Raumes befinden.

11. Vorrichtung nach einem der vorstehenden Ansprüche 1, 2,3,5,6,7,8 oder 10
**dadurch gekennzeichnet, daß** die Vorrichtung ein MRI-System umfaßt,
wobei zumindest ein erster (2) und ein zweiter (1) Sensor sowie ein Nutzsignalsensor des MRI-Systems innerhalb des durch die Helmholtzspulen gebildeten Helmholtzkäfigs (4) angeordnet sind.

12. Verfahren zur aktiven Kompensation magnetischer und/oder elektromagnetischer Störfelder in einem vorgegebenen Volumenbereich mittels mindestens einer Helmholtzspule, welche diesen Volumenbereich im wesentlichen umschließt, und einer Einrichtung zur Ansteuerung der Helmholtzspule in Abhängigkeit von Sensorsignalen,
bei welcher mindestens ein erster Sensor (2) innerhalb des vorgegebenen Volumenbereichs zur Erzeugung eines Signals (2a), das vom magnetischen und/oder elektromagnetischen Feld am Ort des ersten Sensors (2) abhängt, angeordnet ist und das Signal des ersten Sensors als Eingangssignal (3b) zum Ansteuern eines der Helmholtzspule zugehörigen Reglerverstärkers (3) verwendet wird,
**dadurch gekennzeichnet, daß**
mindestens ein zweiter Sensor (1) außerhalb des vorgegebenen Volumenbereichs zur Erzeugung eines Signals (1a), das vom magnetischen und/oder elektromagnetischen Feld am Ort des Sensors (1) abhängt, angeordnet ist
und das Signal des zweiten Sensors (1a) auch als Eingangssignal (3a) zum Ansteuern eines der Helmholtzspule zugehörigen Reglerverstärkers (3) verwendet wird.

13. Verfahren nach Anspruch 12,
**dadurch gekennzeichnet,**
**daß** das Signal des ersten Sensors (2a) nach Durchlaufen einer empirisch bestimmten Übertragungsfunktion (H_{S}) am Reglereingang (3b) des digital ausgebildeten Reglerverstärkers (3) anliegt, und
das Ausgangssignal (3c) des digitalen Reglerverstärkers (3) den Strom durch die Helmholtzspulen (4) derartig steuert, daß das elektromagnetische und magnetische Störfeld in dem vorgegebenen Volumenbereich wenigstens teilweise kompensiert wird.

14. Verfahren nach Anspruch 12 oder 13,
**dadurch gekennzeichnet,**
**daß** nach dem Einstellen der Regelparameter des digitalen Reglerverstärkers (3), diese Regelparameter beibehalten werden und die Vorrichtung ohne den ersten Sensor (2) und den Filter (7) betrieben wird.

15. Verwendung einer Vorrichtung nach einem der vorstehenden Ansprüche 1 bis 10 zur aktiven Kompensation elektromagnetischer Störfelder in einem SQUID - System.

16. Verwendung einer Vorrichtung nach einem der vorstehenden Ansprüche 1 bis 11 zur aktiven Kompensation elektromagnetischer Störfelder in einem MRI (Magnetic Resonance Imaging)- System.

17. Verwendung einer Vorrichtung nach einem der vorstehenden Ansprüche 1 bis 10 zur aktiven Kompensation elektromagnetischer Störfelder in einem ESR (Elektronen-Spin-Resonanz) - System.

18. Verwendung einer Vorrichtung nach einem der vorstehenden Ansprüche 1 bis 11 zur aktiven Kompensation elektromagnetischer Storfelder in einem NMR (Nuclear Magnetic Resonance)- System.

19. Verwendung einer Vorrichtung nach einem der vorstehenden Ansprüche 1 bis 10 zur aktiven Kompensation elektromagnetischer Störfelder in einem Elektronenstrahl-System.

20. Verwendung einer Vorrichtung nach einem der vorstehenden Ansprüche 1 bis 10 zur aktiven Kompensation elektromagnetischer Störfelder in einem Beschleuniger-System.

## Claims

1. A device for active compensation of magnetic and/or electromagnetic interference fields in a preset region of space by at least one Helmholtz coil which substantially surrounds the said region of space, and by means of a device for actuating the Helmholtz coil in dependence on sensor signals, wherein at least one first sensor (2) for generating a signal (2a) depending on the magnetic and/or electromagnetic field at the site of the first sensor (2) is disposed inside the preset region and the signal from the first sensor is used as an input signal (3b) for actuating a control amplifier (3) associated with the Helmholtz coil, **characterised in that** at least one second sensor (1) for generating a signal (1a) depending on the magnetic and/or electromagnetic field at the site of the sensor (1) is disposed outside the preset region of space, and the signal from the second sensor (1a) is also used as an input signal (3a) for actuating the control amplifier (3) associated with the Helmholtz coil.

2. A device according to claim 1, **characterised in that** the signal from the first sensor (2a), after running through an empirically determined transmission function (Hs), arrives at the control input (3b) of the control amplifier (3), which is digital, and the output signal (3c) from the digital control amplifier (3) controls the current through the Helmholtz coil (4).

3. A device according to claim 1 or 2, **characterised in that** a number of sensors (1, 2) detect magnetic and/or electromagnetic fields in all three directions of space and their signals are used to actuate the digital control amplifier and the current through the coils of a three-axis Helmholtz cage is controlled by the output signals from the digital control amplifier so that the magnetic and/or electromagnetic interference fields in all three directions of space are substantially compensated within the preset volume.

4. A device according to claim 3, **characterised in that** the preset region of space includes the entire volume inside the Helmholtz cage and consequently the second sensor is disposed outside the Helmholtz cage.

5. A device according to claim 3, **characterised in that** the preset region of space includes a limited portion (8) of space inside the Helmholtz cage and the second sensor is disposed inside the Helmholtz cage.

6. A device according to any of the preceding claims, **characterised in that** at least one sensor (1, 2) out of the first and/or the second sensor is an ESR sensor, an NMR sensor, an MRI sensor, a fluxgate sensor, a coil, a SQUID sensor or a Hall-effect sensor.

7. A device according to any of the preceding claims, **characterised in that** at least one sensor (6) for generating a useful signal (6a) is disposed in the preset space.

8. A device according to claim 7, **characterised in that** at least one sensor (6) for generating a useful signal (6a) and the interference signal (2a) is included.

9. A device according to any of the preceding claims 1, 2, 3, 4, 6, 7 or 8, **characterised in that** the device comprises a magnetically shielded room (MSR), wherein the Helmholtz coils (4) and at least one second sensor (1) are disposed outside the preset region of space and at least one first sensor (2) is disposed inside the magnetically shielded room.

10. A device according to any of the preceding claims 1, 2, 3, 5, 6, 7 or 8, **characterised in that** the device comprises a magnetically shielded room (MSR), wherein the Helmholtz coils (4) are disposed outside and the preset region of space and the first (2) and the second (1) sensor are disposed inside the magnetically shielded room.

11. A device according to any of the preceding claims 1, 2, 3, 5, 6, 7, 8 or 10, **characterised in that** the device comprises an MRI system, wherein at least one first (2) and one second (1) sensor and a useful-signal sensor of the MRI system are disposed inside the Helmholtz cage formed by the Helmholtz coils.

12. A method of active compensation of magnetic and/or electromagnetic interference fields in a preset region of space by at least one Helmholtz coil substantially surrounding the said region of space and by means of a device for actuating the Helmholtz coil in dependence on sensor signals, wherein at least one first sensor (2) is disposed inside the preset region of space for generating a signal (2a) depending on the magnetic and/or electromagnetic field at the site of the first sensor (2), and the signal from the first sensor is used as an input signal (3b) for actuating a control amplifier (3) associated with the Helmholtz coil, **characterised in that** at least one second sensor (1) is disposed outside the preset region of space for generating a signal (1a) depending on the magnetic and/or electromagnetic field at the site of the sensor, and the signal from the second sensor (1a) is also used as an input signal for actuating a control amplifier (3) associated with the Helmholtz coil.

13. A method according to claim 12, **characterised in that** the signal from the first sensor (2a), after running through an empirically determined transmission function (Hₛ), arrives at the control input (3b) of the control (Hₛ) amplifier (3), which is digital, and the output signal (3c) from the digital control amplifier (3) controls the current through the Helmholtz coils (4) so that the electromagnetic and magnetic interference field is at least partly compensated in the preset region of space.

14. A method according to claim 12 or 13, **characterised in that** after the control parameters of the digital control amplifier (3) have been set, the said control parameters are retained and the device is operated without the first sensor (2) and the filter (7).

15. Use of a device according to any of the preceding claims 1 to 10 for active compensation of electromagnetic interference fields in a SQUID system.

16. Use of a device according to any of the preceding claims 1 to 11 for active compensation of electromagnetic interference fields in an MRI (magnetic resonance imaging) system.

17. Use of a device according to any of the preceding claims 1 to 10 for active compensation of electromagnetic interference fields in an ESR (electron spin resonance) system.

18. Use of a device according to any of the preceding claims 1 to 11 for active compensation of electromagnetic interference fields in an NMR (nuclear magnetic resonance) system.

19. Use of a device according to any of the preceding claims 1 to 10 for active compensation of electromagnetic interference fields in an electron beam system.

20. Use of a device according to any of the preceding claims 1 to 10 for active compensation of electromagnetic interference fields in an accelerator system.

## Revendications

1. Dispositif pour la compensation active de champs parasitaires magnétiques et/ou électromagnétiques dans une zone de volume prédéterminée au moyen d'au moins une bobine de Helmholtz, qui entoure globalement cette zone de volume, et un dispositif pour la commande de la bobine de Helmholtz en fonction de signaux de capteur,
dans lequel au moins un premier capteur (2) pour la production d'un signal (2a) qui dépend du champ magnétique et/ou électromagnétique à l'emplacement du premier capteur (2) est agencé à l'intérieur de la zone de volume prédéterminée et le signal du premier capteur est utilisé comme signal d'entrée (3b) pour la commande d'un amplificateur de régulateur (3) associé à la bobine de Helmholtz,
**caractérisé en ce qu'**au moins un deuxième capteur (1) pour la production d'un signal (1a) qui dépend du champ magnétique et/ou électromagnétique à l'emplacement du capteur (1) est agencé à l'extérieur de la zone de volume prédéterminée et le signal du deuxième capteur (1a) est aussi utilisé comme signal d'entrée (3a) pour la commande de l'amplificateur de régulateur (3) associé à la bobine de Helmholtz.

2. Dispositif selon la revendication 1, **caractérisé en ce que** le signal du premier capteur (2a) se trouve après le passage d'une fonction de transfert déterminée de manière empirique (H_{S}) à l'entrée de régulateur (3b) de l'amplificateur de régulateur conçu numérique (3) et en ce que le signal de sortie (3c) de l'amplificateur de régulateur numérique (3) commande le courant passant à travers la bobine de Helmholtz (4).

3. Dispositif selon la revendication 1 ou 2, **caractérisé en ce que** plusieurs capteurs (1, 2) détectent des champs magnétiques et/ou électromagnétiques dans les trois directions de l'espace et leurs signaux sont utilisés pour la commande de l'amplificateur de régulateur numérique et en ce que le courant passant à travers les bobines d'une cage de Helmholtz à trois axes est commandé de telle sorte avec les signaux de sortie de l'amplificateur de régulateur numérique que les champs parasitaires magnétiques et/ou électromagnétiques dans les trois directions de l'espace à l'intérieur du volume prédéterminé sont globalement compensés.

4. Dispositif selon la revendication 3, **caractérisé en ce que** la zone de volume prédéterminée comprend tout le volume à l'intérieur de la cage de Helmholtz et en ce que le deuxième capteur est donc agencé à l'extérieur de la cage de Helmholtz.

5. Dispositif selon la revendication 3, **caractérisé en ce que** la zone de volume prédéterminée inclut une partie de volume limitée (8) à l'intérieur de la cage de Helmholtz et en ce que le deuxième capteur est agencé à l'intérieur de la cage de Helmholtz.

6. Dispositif selon l'une des revendications précédentes, **caractérisé en ce qu'**au moins un capteur (1, 2) du premier et/ou du deuxième capteur est un capteur ESR, un capteur NMR, un capteur MRI, un capteur Flux Gate, une bobine, un capteur SQUID ou un capteur à effet Hall.

7. Dispositif selon l'une des revendications précédentes, **caractérisé en ce qu'**au moins un capteur (6) pour la production d'un signal utile (6a) est agencé dans le volume prédéterminé.

8. Dispositif selon la revendication 7, **caractérisé en ce qu'**au moins un capteur (6) pour la production d'un signal utile (6a) et du signal parasitaire (2a) est compris dedans.

9. Dispositif selon l'une des revendications précédentes 1, 2, 3, 4, 6, 7 ou 8, **caractérisé en ce que** le dispositif comprend un espace à protection antimagnétique (MSR), les bobines de Helmholtz (4) et au moins un deuxième capteur (1) se trouvant à l'extérieur de l'espace à protection antimagnétique et la zone de volume prédéterminée ainsi qu'au moins un premier capteur (2) se trouvant à l'intérieur de l'espace à protection antimagnétique.

10. Dispositif selon l'une des revendications précédentes 1, 2, 3, 5, 6, 7 ou 8, **caractérisé en ce que** le dispositif comprend un espace à protection antimagnétique (MSR), les bobines de Helmholtz (4) se trouvant à l'extérieur de l'espace à protection antimagnétique et la zone de volume prédéterminée ainsi que le premier capteur (2) et le deuxième capteur (1) se trouvant à l'intérieur de l'espace à protection antimagnétique.

11. Dispositif selon l'une des revendications précédentes 1, 2, 3, 5, 6, 7, 8 ou 10, **caractérisé en ce que** le dispositif comprend un système MRI, au moins un premier capteur (2) et un deuxième capteur (1) ainsi qu'un capteur de signal utile du système MRI étant agencés à l'intérieur de la cage de Helmholtz (4) formée par les bobines de Helmholtz.

12. Procédé pour la compensation active de champs parasitaires magnétiques et/ou électromagnétiques dans une zone de volume prédéterminée au moyen d'au moins une bobine de Helmholtz, qui entoure globalement cette zone de volume, et un dispositif pour la commande de la bobine de Helmholtz en fonction de signaux de capteur,
dans lequel au moins un premier capteur (2) pour la production d'un signal (2a) qui dépend du champ magnétique et/ou électromagnétique à l'emplacement du premier capteur (2) est agencé à l'intérieur de la zone de volume prédéterminée et on utilise le signal du premier capteur comme signal d'entrée (3b) pour la commande d'un amplificateur de régulateur (3) associé à la bobine de Helmholtz,
**caractérisé en ce qu'**au moins un deuxième capteur (1) pour la production d'un signal (1a) qui dépend du champ magnétique et/ou électromagnétique à l'emplacement du capteur (1) est agencé à l'extérieur de la zone de volume prédéterminée et on utilise aussi le signal du deuxième capteur (1a) comme signal d'entrée (3a) pour la commande d'un amplificateur de régulateur (3) associé à la bobine de Helmholtz.

13. Procédé selon la revendication 12, **caractérisé en ce que** le signal du premier capteur (2a) se trouve après le passage d'une fonction de transfert déterminée de manière empirique (H_{S}) à l'entrée de régulateur (3b) de l'amplificateur de régulateur conçu numérique (3) et en ce que le signal de sortie (3c) de l'amplificateur de régulateur numérique (3) commande le courant passant à travers les bobines de Helmholtz (4) de telle sorte que le champ parasitaire magnétique et électromagnétique dans la zone de volume prédéterminée est au moins partiellement compensé.

14. Procédé selon la revendication 12 ou 13, **caractérisé en ce qu'**après le réglage des paramètres de régulation de l'amplificateur de régulateur numérique (3), on conserve ces paramètres de régulation et on fait fonctionner le dispositif sans le premier capteur (2) ni le filtre (7).

15. Utilisation d'un dispositif selon l'une des revendications précédentes 1 à 10 pour la compensation active de champs parasitaires électromagnétiques dans un système SQUID.

16. Utilisation d'un dispositif selon l'une des revendications précédentes 1 à 11 pour la compensation active de champs parasitaires électromagnétiques dans un système MRI (Magnetic Resonance Imaging ou imagerie par résonance magnétique IRM).

17. Utilisation d'un dispositif selon l'une des revendications précédentes 1 à 10 pour la compensation active de champs parasitaires électromagnétiques dans un système ESR (Elektronen-Spin-Resonanz ou résonance de spin électronique RSE).

18. Utilisation d'un dispositif selon l'une des revendications précédentes 1 à 11 pour la compensation active de champs parasitaires électromagnétiques dans un système NMR (Nuclear Magnetic Resonance ou résonance magnétique nucléaire RMN).

19. Utilisation d'un dispositif selon l'une des revendications précédentes 1 à 10 pour la compensation active de champs parasitaires électromagnétiques dans un système à rayon électronique.

20. Utilisation d'un dispositif selon l'une des revendications précédentes 1 à 10 pour la compensation active de champs parasitaires électromagnétiques dans un système à accélérateur.
